(19)

Europäisches
Patentamt
European
Patent Office
Office européen
des brevets

(11) **EP 3 866 344 A1**

(12) **EUROPEAN PATENT APPLICATION**

(43) Date of publication:
**18.08.2021 Bulletin 2021/33**

(51) Int Cl.:
**H03M 1/06** *(2006.01)*   **H03M 1/16** *(2006.01)*

(21) Application number: **20157326.8**

(22) Date of filing: **14.02.2020**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicants:
• **Imec VZW**
**3001 Leuven (BE)**
• **University of Macau**
**Taipa, Macau (CN)**

(72) Inventors:
• **Zheng, Zihao**
**3001 Leuven (BE)**
• **Wei, Lai**
**3001 Leuven (BE)**
• **Chan, Chi-hang**
**3001 Leuven (BE)**
• **Craninckx, Jan**
**3001 Leuven (BE)**
• **Lagos Benites, Jorge Luis**
**3001 Leuven (BE)**

(74) Representative: **IP HILLS NV**
**Hubert Frère-Orbanlaan 329**
**9000 Gent (BE)**

(54) **PIPELINED ANALOGUE TO DIGITAL CONVERTER**

(57)    Example embodiments describe a pipelined analogue to digital converter (100), ADC, comprising stages (120, 140) operable during a first and second clock phase; a stage respectively comprising means for performing during the first clock phase i) receiving (124) an analogue output signal (111) from a preceding stage (110); and during the second clock phase (ii) receiving (127) a digital output signal (112) of the preceding stage (110) and converting (127) it to a quantized analogue signal (128); iii) amplifying (125) a difference (123) between the analogue output signal and the quantized analogue signal thereby obtaining a next analogue output signal (121) for a next stage (140); and iv) quantizing (126) the difference thereby obtaining a next digital output signal (122) for the next stage (140).

Fig. 1

## Description

### Technical Field

Various example embodiments relate to a pipelined analogue to digital converter, ADC, comprising stages operable in a first and second clock phase.

### Background

A pipelined analogue to digital converter, ADC, converts an analogue input signal to a digital output signal employing a plurality of stages that operate concurrently. Functionally, a pipelined ADC can be subdivided into different subsequent stages that each resolve a portion of the digital output signal from the most significant bit up to the least significant bit. Each stage takes a residue analogue output signal of the preceding stage as input and derives therefrom the residue signal for the next stage and a subset of the ADC output bits. A stage of a synchronous pipelined ADC operates in two clock phases according to a two-phased clock. During the first phase, the analogue input of the previous stage is sampled and during the second phase, the analogue input for the next stage is produced. The clocking of subsequent stages is then alternated such that the signal is passed from one stage to the other.

By the concurrent operation, a pipelined ADC can achieve high sampling rates within a small footprint.

### Summary

Amongst others, it is an object of embodiments of the invention to provide a pipelined ADC with a high sampling speed while preserving low power consumption.

This object is achieved, according to a first example aspect of the present disclosure, by a pipelined analogue to digital converter, ADC, comprising stages operable during a first and second clock phases. A stage respectively comprises means for performing, during the first clock phase: i) receiving an analogue output signal from a preceding stage. A stage respectively further comprising means for performing, during the second clock phase: i) receiving a digital output signal of the preceding stage and converting it to a quantized analogue signal; ii) amplifying a difference between the analogue output signal and the quantized analogue signal thereby obtaining a next analogue output signal for a next stage; and iii) quantizing the difference thereby obtaining a next digital output signal for the next stage.

By the above configuration of the pipeline stages, the quantization and amplification are both performed on the so-obtained difference during the second clock phase. In other words, the amplifying and quantizing may be performed in parallel during the second clock phase. Hence, the outcome of the quantization does not depend on the outcome of the amplification or the other way around during the same clock cycle. This results in a short critical path, i.e. shorter than in pipeline configurations wherein the critical path is determined by an aggregation of the quantization and the amplification.

The stages are operable during a first and second clock phase. Subsequent stages are then operable according to opposite clock phases, i.e. when a stage is operating according to the second clock phase, then both the preceding and next stage will be operating according to the first clock phase.

According to example embodiments, the means further comprise an amplifier operable in closed-loop feedback for performing the amplifying.

According to example embodiments the means further comprise a dynamic open-loop amplifier for performing the amplifying. Such open-loop amplifier has no feedback mechanism for supplying a stable constant voltage amplification but provides a constant voltage-to-current conversion according to a transconductance. By adjusting a configurable interval during which the amplifier is operable within the second clock phase with respect to its load, a constant input-to-output amplification is achieved. An advantage of an open-loop amplifier is that it may be faster than a closed-loop amplifier. Furthermore, due to its time interval based operation, power consumption will be dynamic such that a lower power consumption than a statically-biased amplifier can be achieved.

According to an example embodiment, the dynamic open-loop amplifier further comprises a differential input transistor pair configured to convert the difference applied as a differential input voltage to a differential output current according to a transconductance during a configurable time interval, and to charge a capacitive load with the differential current thereby producing the next analogue output signal at the end of the time interval. Advantageously, the dynamic open-loop amplifier further comprises a source-degeneration circuitry between the source nodes of the differential input transistor pair.

According to a further example embodiment, the dynamic open-loop amplifier further comprises linearization circuitries configured to draw a linearization current from the source of a respective transistor of the differential input transistor pair; and wherein the linearization current is proportional to the input applied to the respective transistor of the differential input transistor pair.

A total linearization current, i.e. the current drawn from both sources together will thus be 2nd-order proportional to the sum of the voltages applied at the differential input transistor pair. This allows compensating the non-linear 2nd-order component in the transconductance of the differential input transistor pair that is 2nd-order proportional to the difference of the voltages applied at the differential input transistor pair.

According to example embodiments the linearization circuitries comprise a respective transistor configured to draw the linearization current from the source of the respective differential pair transistor.

According to further example embodiments, the means further comprise i) at least one comparator for performing the quantizing; ii) a digital to analogue converter, DAC, for performing the converting; and/or iii) at least one switch and at least one capacitor for performing the receiving the analogue output signal by sampling the analogue output signal onto the capacitor.

According to a second example aspect, the disclosure relates to a dynamic open-loop amplifier comprising a differential input transistor pair configured to convert a differential input voltage to a differential output current according to a transconductance during a configurable time interval, and to charge a capacitive load with the differential current thereby obtaining a differential output voltage. The dynamic open-loop amplifier further comprises a source degeneration circuitry between the source nodes of the differential input transistor pair. The dynamic open-loop amplifier further comprises linearization circuitries configured to draw a linearization current from the source of a respective transistor of the differential input transistor pair; and wherein the linearization current is proportional to the input applied to the respective transistor of the differential input transistor pair.

The linearization circuitries may further comprise a respective transistor configured to draw the linearization current.

According to a third example aspect, the disclosure relates to an integrated circuit comprising an ADC according to the first example aspect.

According to a fourth example aspect, the disclosure relates to a method for performing analogue to digital conversion by a synchronous pipeline of subsequent stages comprising a respective stage performing during a first clock phase i) receiving an analogue output signal from a preceding stage; and during a second clock phase i) receiving a digital output signal of the preceding stage and converting it to a quantized analogue signal; ii) amplifying a difference between the analogue output signal and the quantized analogue signal thereby obtaining a next analogue output signal for a next stage; and iii) quantizing the difference thereby obtaining a next digital output signal for the next stage.

## Brief Description of the Drawings

Some example embodiments will now be described with reference to the accompanying drawings.

Fig. 1 shows an example embodiment of a pipelined ADC architecture comprising a plurality of stages;

Fig. 2 shows an example timing diagram of the ADC of Fig. 1;

Fig. 3 shows an example embodiment of a stage of a pipelined ADC architecture employing closed-loop amplification;

Fig. 4 shows a timing diagram of two stages of a pipelined ADC according to an example embodiment;

Fig. 5 shows another example embodiment of a stage of a pipelined ADC architecture employing open-loop amplification; and

Fig. 6 shows an example embodiment of a dynamic open-loop amplifier according to an example embodiment.

## Detailed Description of Embodiment(s)

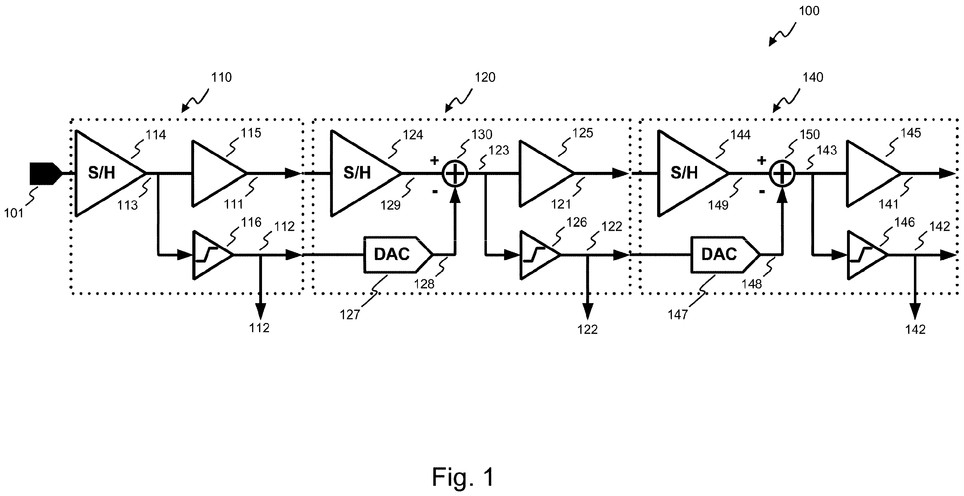

In Fig. 1 a pipelined analogue to digital converter, ADC, architecture 100 according to an example embodiment is shown. The ADC 100 comprises a first input stage 110 configured to receive an analogue input signal at its input 101. Input stage 110 further comprises a sample-and-hold circuitry 114 configured to sample the input signal for a first clock phase and then to hold the sampled input signal 113 during a second clock phase. Input stage 110 further comprises an amplifier 115 for amplifying the sampled input signal 113 by a predetermined gain to an amplified output signal 111. Input stage 110 further comprises a quantization circuitry 116 that generates during the second clock phase one of a plurality of discrete output levels 112 depending on the value of the sample input signal 113. The discrete output levels 112 represent respective binary values or, in other words, a digital output signal 112. Quantization circuitry 116 may for example be formed as a comparator that outputs a one or zero when the sampled input signal 113 is respectively above or below a threshold value. Alternatively, it may be formed by a plurality of comparators each of which outputs a one or zero when the sampled input signal 113 is respectively above or below one of several different threshold values, thereby achieving multi-bit quantization. By the quantization of the sampled input value, digital output value 112 represents the most significant bits of the binary representation of the sampled input value 113.

ADC 100 further comprises one or more subsequent stages 120, 140. A stage 120, 140 comprises a sample-and-hold circuitry 124, 144 configured to receive the input analogue signal 111, 121 during a first clock phase for use as a sampled analogue signal 129, 149 by the same stage during a next clock phase. A stage 120, 140 further comprises a digital to analogue, DAC, circuitry 127, 147 configured to receive the digital output value 112, 122 from a preceding stage and to convert that binary value into an analogue representation, i.e. analogue signal 128, 148. A stage 120, 140, further comprises means 130, 140 for subtracting the obtained analogue signal 128, 148 from the sampled analogue signal 129, 149 thereby obtaining a residual analogue signal 123, 143. A stage 120, 140 further comprises an amplification circuitry 125, 145 configured to amplify the residual analogue signal 123, 143 to an amplified analogue signal 121, 141 serving as analogue input signal of the next stage. A stage 120, 140 also comprises quantization circuitry 126, 146 which may be operable in the same way as quantization circuitry 116. The so-obtained digital output signal 122, 142 then serves as input for the next stage and also represents the next significant bits of the binary representation of the sampled input value 113.

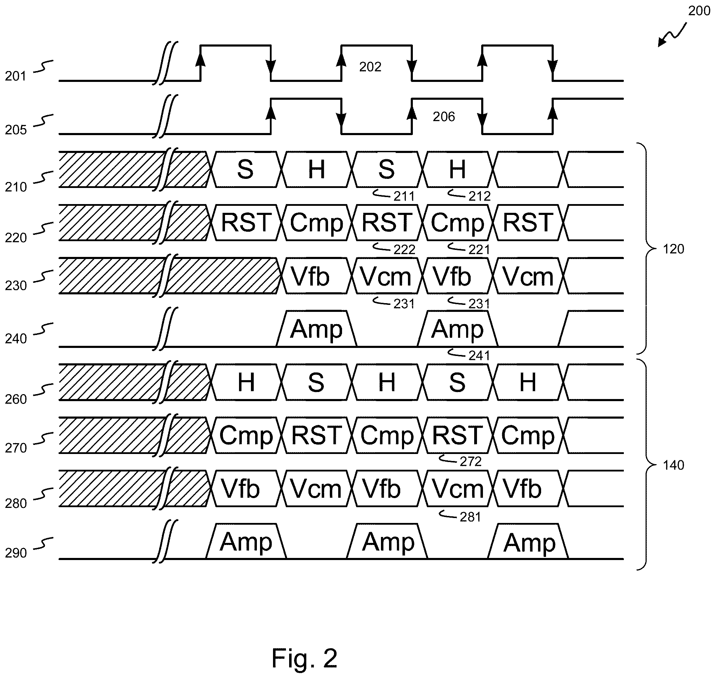

Fig. 2 shows a timing diagram 200 for operating stages 120 and 140 of the ADC 100. The different horizontal bars 210, 220, 230 and 240 illustrate the different states of the circuitries of stage 120 in time from left to right. Likewise, the different horizontal bars 260, 270, 280 and 290 illustrate the different states of the circuitries of stage 140 in time from left to right. Bars 210, 260 represent the respective sample-and-hold circuitries 124, 144; bars 220, 270 represent the respective quantization circuitries 126, 146; bars 230, 280 represent the respective DACs 127, 147; and bars 240, 290 represent the respective amplification circuitries 125, 145.

At a certain moment in time, during a clock phase 202, the sample-and-hold circuitry 124 samples the analogue output value 111 of input stage 110 as indicated by state'S' 211. At the same moment, quantization circuitry 126 is in a reset state 'RST' 222 during which it is being reset and DAC 127 feeds a constant reference voltage 'Vcm' required for the sampling operation. Then, during the next clock cycle 206, the sample-and-hold circuitry 124 holds the sampled value 129 as indicated by state 'H' 212; quantization circuitry 126 quantizes the residual analogue signal 123 as indicated by the state 'Cmp' 221; amplification circuitry 125 amplifies residual analogue value 123 to analogue output signal 121; and DAC 127 outputs the analogue value 128 corresponding to the digital output 112 of the first stage computed during the previous cycle.

Stage 140 is operated similarly as stage 120 but with opposite clock cycles 201, 205. Therefore, during clock phase 206, the sample-and-hold circuitry 144 of stage 140 samples the output of amplification circuitry 125 and then holds the last value of the output during the next cycle. At the same moment, quantization circuitry 146 is in reset state 'RST' 272 during which it is being reset and DAC 147 feeds a constant reference voltage 'Vcm' 281 required for the sampling operation. When clock cycle 206 is finished, stage 140 operates in an identical way as stage 120 during clock phase 202.

The input signals described with reference to the ADC of Fig. 1 and Fig. 2 may be represented by single-ended voltages, single-ended currents, differential voltages, and/or differential currents.

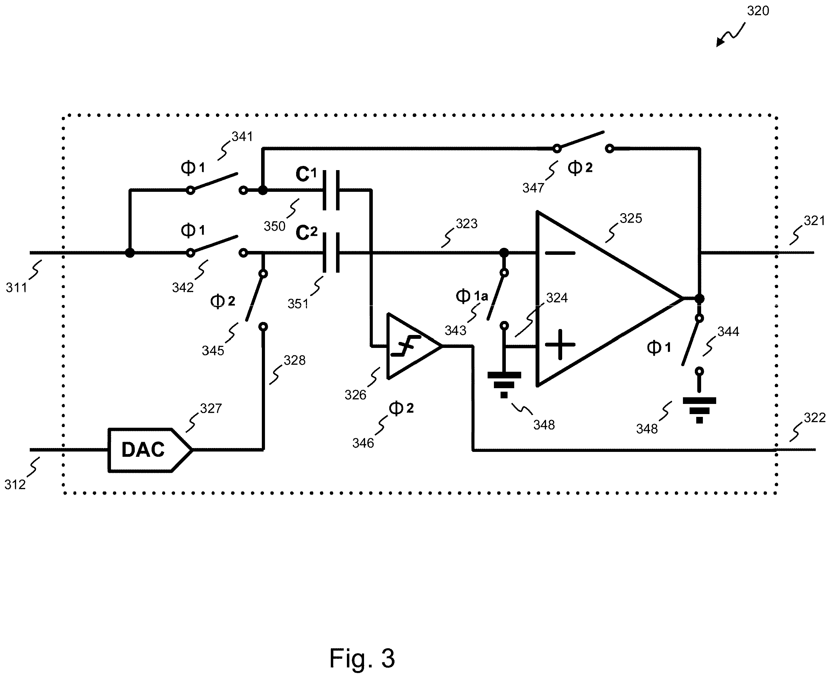

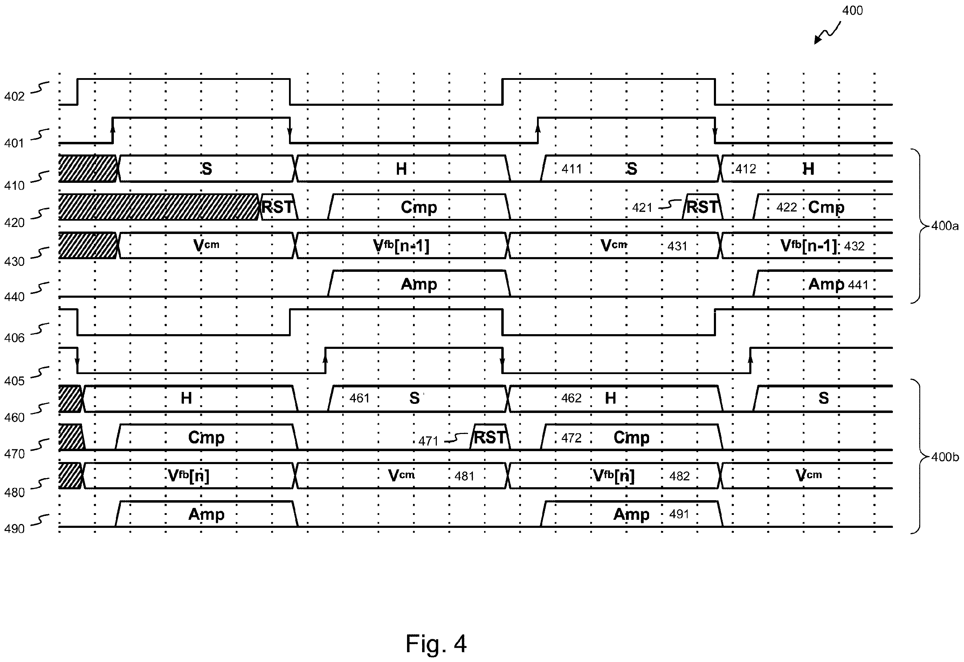

Fig. 3 illustrates a stage 320 of a pipelined ADC according to a further example embodiment of stages 120, 140, i.e. stage 320 may functionally be represented by stage 120, 140 and its operation by timing diagram 200. Fig. 4 illustrates a more detailed timing diagram 400 for two subsequent instances 400a, 400b of stage 320.

Stage 320 comprises two switches 341, 342 that sample the analogue residual signal 311 from the previous stage onto respective capacitors 350, 351 during the first clock phase, i.e. switches 341, 342 are closed during the first clock phase. Stage 320 further comprises a switch 343 that closes just before the first clock is de-asserted and connects the capacitors 350, 351 with a constant reference voltage at node 348. The operation of switches 341, 342 and 343 and capacitors 350, 351 corresponds to the sample-and-hold circuitry 124, 144. The sample-and-hold operation is represented in Fig. 4 by bars 410, 460 for respective stages 400a, 400b. Stage 400a is configured to perform a sampling operation 'S' 411 during clock phase 401 and a holding operation 'H' during clock phase 406. Stage 400b is configured to perform a sampling operation 'S' 461 during clock phase 405 and a holding operation 'H' during clock phase 402, i.e. each of stages 400a and 400b operates under opposite clock phases than a preceding or subsequent stage.

Stage 320 further comprises a DAC 327 and a switch 345 that connects the output of the DAC with capacitor 351 during the second clock phase. During the first clock phase switch 345 is opened and the analogue output signal 328 of DAC 327 is not connected to capacitor 351. During the second clock phase, DAC 327 receives the output of the quantization circuitry of the preceding stage, performs the digital to analogue conversion of the received digital signal 312 and outputs the resulting constant analogue signal 328 that is applied to one of the nodes of capacitor 351. The operation of DAC 327 and switch 345 corresponds to that of DAC 127, 147 of Fig. 1 and bars 230, 280 of Fig. 2. The operation of DAC 327 and switch 345 is represented in more detail in Fig. 4 by bars 430, 480 for respective stages 400a, 400b. In stage 400a, DAC 430 performs the digital to analogue conversion and outputs the converted voltage 432 during phase 405. In stage 400b, DAC 480 performs the digital to analogue conversion and outputs the converted voltage 482 during phase 401.

Stage 320 further comprises an amplifier 325. During the first phase, amplifier 325 is connected with both its inputs 323, 324 and output 321 to a constant reference voltage at node 348 by respective switches 343, 344. During the second phase, amplifier 325 is configured in a closed-loop configuration by coupling the capacitor 350 between output 321 and inverting input 323 by means of switch 347. During the second phase, capacitor 351 is coupled between the output 328 of DAC 327 and the inverting input 323 of amplifier 325. During the second phase, the operation of amplifier 325 and the capacitors 350, 351 corresponds to the combination of the subtraction circuitry 130, 150 and the amplification circuitry 125, 145. The achieved gain is then determined by the ratio of the capacitances of capacitors 350 and 351. By the closed-loop amplifier, a voltage to voltage amplification is obtained by the end of the second clock phase. Due to the closed-loop operation, the amplified value will settle slowly towards the end of the second clock phase. The operation of the closed-loop amplifier circuitry is represented in more detail in Fig. 4 by bars 440, 490 for respective stages 400a, 400b. In stage 400a, circuitry 440 performs the amplification 441 during the phase 405. In stage 400b, circuitry 490 performs the amplification 491 during the phase 401.

Stage 320 further comprise a comparator 326 that is operable during the second phase by input signal 346. The operation of comparator 326 corresponds to that of comparator 126, 146 and 220, 270. The operation of the comparator 326 is represented in more detail in Fig. 4 by bars 420, 470 for respective stages 400a, 400b. In stage 400a, comparator 420 is reset during phase 401 and performs the quantization 422 during phase 405. In stage 400b, comparator 470 is reset during phase 405 and performs the quantization 472 during phase 401.

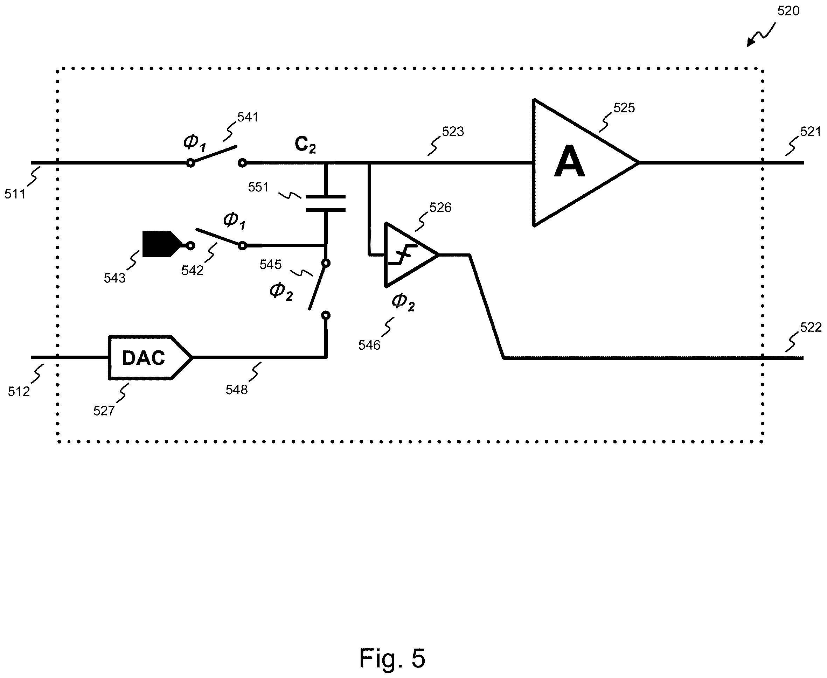

Fig. 5 illustrates a stage 520 of a pipelined ADC according to another further example embodiment of stages 120, 140, i.e. stage 520 may functionally be represented by stage 120, 140 and its operation by timing diagram 200. The timing of stage 520 may be illustrated by the same timing diagram 400 for two subsequent instances 400a, 400b of stage 520.

Stage 520 comprises a switch 541 that samples the analogue residual signal 511 from the previous stage onto capacitor 551. The other node of capacitor 551 is connected to a constant reference voltage at node 543 during the first clock phase. The operation of switches 541, 542 and capacitor 551 corresponds to the sample-and-hold circuitry 124, 144.

Stage 520 further comprises a DAC 527 and a switch 545 that connects the output of the DAC with capacitor 551 during the second clock phase. During the first clock phase switch 545 is opened and the analogue output signal 528 of DAC 527 is not connected to capacitor 551. During the second clock phase, DAC 527 receives the output 512 of the quantization circuitry of the preceding stage, performs the digital to analogue conversion of the received digital signal 512, outputs the resulting constant analogue signal 528 and applies it to the other node of capacitor 551. The operation of DAC 527 and switch 545 corresponds to that of DAC 127, 147 of Fig, 1 and bars 230, 280 of Fig. 2.

Stage 520 further comprises a dynamic open-loop amplifier 525. During the first phase, the input node 523 of amplifier 525 is floating and will thus correspond to input signal 511. During the second phase, the applied input voltage 523 will be determined by the difference between the converted analogue signal 548 and the applied input signal 511. The input signal is then amplified by the dynamic open-loop amplifier 525 according to a transconductance gm during a preconfigured time interval. By the transconductance, a current proportional to the applied input voltage 523 will be produced at the output node 521 and will charge the input capacitor 551 of the subsequent stage during the preconfigured time interval. At the end of the preconfigured time interval, the voltage over capacitor 551 of the next stage will be proportional to the applied input voltage 523. In other words, input voltage 523 will be amplified by a predetermined gain to an output voltage 521. During the second phase, the operation of amplifier 525 and the capacitor 551 corresponds to the combination of the subtraction circuitry 130, 150 and the amplification circuitry 125, 145. Due to the open-loop operation, the amplified value will be obtained very fast.

Stage 520 further comprises a comparator 526 that is operable during the second phase by input signal 546. The operation of comparator 526 corresponds to that of comparator 126, 146 and 220, 270.

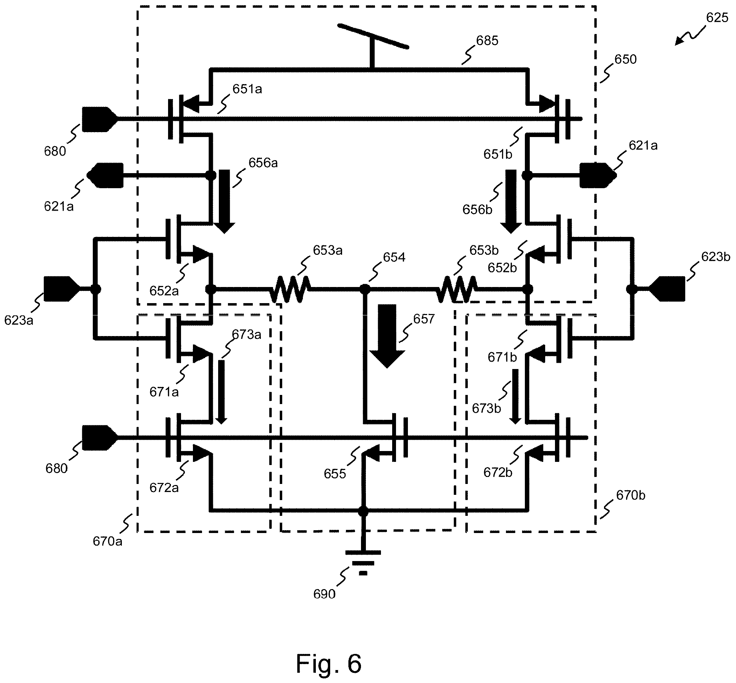

Fig. 6 illustrates an example embodiment of a dynamic open-loop amplifier 625. Amplifier 625 may for example be used as amplifier 525 in a stage 520 of a pipelined ADC 100 wherein the stage 520 is arranged in a differential operation mode. Amplifier 625 comprises a differential input transistor pair 652a, 652b that is dynamically operated by means of transistors 651a, 651b, and 655 that are configured as switches and operable by applying an enabling signal at the inputs 680. When the enabling signal is high, e.g. equal to supply voltage 685, switches 651a and 651b are open and switch 655 is closed and the amplifier 625 is enabled. When the enabling signal is low, e.g. connected to ground node 690, then the amplifier 625 is disabled. The so formed amplifier 650 takes a differential input voltage at its inputs 623a, 623b. This differential input voltage may correspond to a differential version of input signal 523 in stage 520. To improve linearity, the input transistor pair 652a, 652b is degenerated at its sources, i.e. source degenerated, by means of two resistors 653a and 653b connected between the respective sources of transistors 652a and 652b and the common node 654. This node 654 is connected to the ground node 690 by switch 655 when the amplifier is enabled. The output nodes 621a, 621b are formed at the drains of the differential input transistor pair and connected to a capacitive load when enabled. When enabled, the differential input transistor pair converts the voltages applied at input nodes 623a, 623b to currents 656a, 656b that are drawn from the capacitive load. The size of these currents 656a, 656b is then determined by the transconductance of the differential input transistor pair and the applied differential input voltage. After a pre-defined time interval, the voltage over the capacitive load will be proportional to the previously applied differential input voltage.

Amplifier 625 may further comprise linearization circuitries 670a, 670b respectively comprising a switching transistor 672a, 672b operated by enabling signal 680 and input transistors 671a, 671b operated by input signal 623a, 623b. During operation, circuitries 670a, 670b, will draw a linearization current 673a, 673b. By this linearization current, the non-linearity of the transconductance of input transistor pair 652a, 652b is compensated, i.e. the transconductance will vary less with the amplitude of the applied input signal. Without linearization circuitries 670a, 670b and source degeneration, the differential output current may be represented as follows:

$$I_{D1} - I_{D2} = k(V_{I+} - V_{I-})\sqrt{\frac{4(I_{CM})}{k} - (V_{I+} - V_{I-})^2} \quad (eq.\,1)$$

wherein $k$ is a constant; $I_{D1}$ and $I_{D2}$ are the currents 656a and 656b through respective transistors 652a and 652b; $I_{CM} = I_{D1} + I_{D2}$ is the common mode current 657; and $V_{I+}$ and $V_{I-}$ are the input voltages applied at respective input nodes 623a and 623b. From this equation it can be observed that the current to voltage characteristic is not linear but approximately 2nd-order. The differential output current grows less than desired, i.e. compresses, for large inputs. By the linearization circuitries, respective currents $I_{D1AUX}$ 673a and $I_{D2AUX}$ 673b are introduced that may be represented as follows:

$$I_{D1AUX} = k_1(V_{I+} - V_{TH})^2 = c - 2k_1 V_{TH} V_{I+} + \alpha k_1 V_{I+}^2 \quad (eq.\,2a)$$

$$I_{D2AUX} = k_1(V_{I-} - V_{TH})^2 = c - 2k_1 V_{TH} V_{I-} + \alpha k_1 V_{I-}^2 \quad (eq.\,2b)$$

and therefrom

$$I_{D1AUX} + I_{D2AUX} = 2c + \alpha k_1(V_{I+}^2 + V_{I-}^2) \quad (eq.\,2c)$$

wherein $c$, $\alpha$ and $k_1$ are parameters of transistors 671a and 671b. The linearization circuitries thus introduce a common mode current which has a second order dependency on the input. This dependency may then be used to compensate for the second order dependency in above eq.1. With linearization circuitries 670a, 670b and source degeneration, the differential output current may now be represented as follows:

$$I_{D1} - I_{D2} = k(V_{I+} - V_{I-})\sqrt{\frac{4(I_{CM} + 2c + \alpha k_1(V_{I+}^2 + V_{I-}^2))}{k} - (V_{I+} - V_{I-})^2} \quad (eq.\,3)$$

As a result, the amplitude of the 2nd-order signal component in the square-root portion of the equation is compressed. This results in a more linear relation between the differential output current $I_{D1} - I_{D2}$ and the differential input voltage $V_{I+} - V_{I-}$.

An instance of amplifier 625 was designed in a 28nm planar 0.9V CMOS process with the dimensions of the different transistors according to below Table 1 and with a resistance of 300Ohm for both resistors 653a and 653b. By the application of the source degeneration alone an improvement in total harmonic distortion, THD, of 6dB was achieved. By the additional linearization circuitries 670a, 670b, another 10dB THD improvement was observed, resulting in a total 16dB THD improvement.

*Table 1: Transistor dimensions of an example embodiment of an open-loop amplifier.*

| Transistors with reference to Fig. 6 | Width [nm] | Length [nm] |
|---|---|---|
| 651a, 651b | 520 | 30 |

(continued)

| Transistors with reference to Fig. 6 | Width [nm] | Length [nm] |
|---|---|---|
| 652a, 652b | 1500 | 120 |
| 671a, 671b | 840 | 80 |
| 672a, 672b | 9600 | 30 |
| 655 | 4200 | 80 |

As a result, the amplifier 625 is capable of working with larger inputs which is beneficial for the operation of stage 520 and of pipelined ADC architecture 100. Furthermore, by the application of this amplifier 625 in stage 520 all blocks in stage 520 are fully dynamic, thereby improving overall power consumption.

Pipelined ADC 100 and stages 120, 320, 520 may further be calibrated to compensate for fabrication variations and mismatches and to achieve maximum performance. Offsets in comparator 116, 326, 526 and amplifier 125, 325, 525 may be detected by shorting the inputs to a reference voltage. Comparator offsets may be further tuned-out by applying an appropriate calibration voltage generated by a DAC to an auxiliary input pair in the comparator until an equal probability of ones and zeros is reached. Amplifier offsets may be detected by quantizing the amplifier outputs using the next-stage comparators and further tuned to zero by adding or removing dummy capacitors from the differential output nodes. The amplifier gain of amplifier 525, 625 may be correctly tuned so that the swing of the output voltage is matched to the amplitude of the reference signal that will be subtracted at its output. The amplifier gain may be controlled by a tuneable delay that sets the time interval during which the amplifier performs the amplification. The stage gain may then be calibrated in a reverse sequence from the last stage up to the first stage. To detect the gain of a certain stage n with already calibrated offsets in the comparator and amplifier, the DAC of the $n^{th}$ stage is configured to generate a voltage with half the range of the DAC. Then, this voltage is amplified in the amplifier of the $n^{th}$ stage and quantized by the $n^{th}$ stage. Both signals are then provided to the next stages with an already calibrated gain. The expected quantization result of this injected voltage when being quantized by the following stages would be half of the full scale. The calibration starts with the minimum gain configuration and increases the gain until this half-full-scale result is obtained. Using this calibration procedure, a 6-bit pipelined ADC having six 1-bit stages 520 with an open-loop amplifier 625 as specified in Table 1 achieves a 34.16 dB SNDR at 3.3 GS/s for a 1.649 GHz input signal after calibration. Power consumption is 5.508 mW from a 0.9 V voltage supply and resulting in a figure of merit of 40.02 fJ per conversion step.

The circuitries described with reference to figure 6 has been described in terms of metal-oxide-silicon, MOS, processing technology. All circuitries according to the above described example embodiments may also be performed by using other semiconductor technologies such as for example silicon-germanium (SiGe), gallium arsenide (GaAs), gallium nitride (GaN), and silicon carbide (SiC), indium phosphide (InP)TBD. Analogously, different types of transistors may be used as available in the selected technology such as a field-effect transistor, FET, and a bipolar junction transistor, BJT. The different circuitries may be implemented as single integrated circuits, ICs, a combination of different integrated circuits or by discrete components connected together on a printed circuit board, PCB.

As used in this application, the term "circuitry" may refer to one or more or all of the following:

(a) hardware-only circuit implementations such as implementations in only analogue and/or digital circuitry and
(b) combinations of hardware circuits and software, such as (as applicable):

(i) a combination of analogue and/or digital hardware circuit(s) with software/firmware and
(ii) any portions of hardware processor(s) with software (including digital signal processor(s)), software, and memory(ies) that work together to cause an apparatus, such as a mobile phone or server, to perform various functions) and

(c) hardware circuit(s) and/or processor(s), such as microprocessor(s) or a portion of a microprocessor(s), that requires software (e.g. firmware) for operation, but the software may not be present when it is not needed for operation.

This definition of circuitry applies to all uses of this term in this application, including in any claims. As a further example, as used in this application, the term circuitry also covers an implementation of merely a hardware circuit or processor (or multiple processors) or portion of a hardware circuit or processor and its (or their) accompanying software and/or firmware. The term circuitry also covers, for example and if applicable to the particular claim element, a baseband integrated circuit or processor integrated circuit for a mobile device or a similar integrated circuit in a server, a cellular network device, or other computing or network device.

Although the present invention has been illustrated by reference to specific embodiments, it will be apparent to those skilled in the art that the invention is not limited to the details of the foregoing illustrative embodiments, and that the present invention may be embodied with various changes and modifications without departing from the scope thereof. The present embodiments are therefore to be considered in all respects as illustrative and not restrictive, the scope of the invention being indicated by the appended claims rather than by the foregoing description, and all changes which come within the scope of the claims are therefore intended to be embraced therein.

It will furthermore be understood by the reader of this patent application that the words "comprising" or "comprise" do not exclude other elements or steps, that the words "a" or "an" do not exclude a plurality, and that a single element, such as a computer system, a processor, or another integrated unit may fulfil the functions of several means recited in the claims. Any reference signs in the claims shall not be construed as limiting the respective claims concerned. The terms "first", "second", third", "a", "b", "c", and the like, when used in the description or in the claims are introduced to distinguish between similar elements or steps and are not necessarily describing a sequential or chronological order. Similarly, the terms "top", "bottom", "over", "under", and the like are introduced for descriptive purposes and not necessarily to denote relative positions. It is to be understood that the terms so used are interchangeable under appropriate circumstances and embodiments of the invention are capable of operating according to the present invention in other sequences, or in orientations different from the one(s) described or illustrated above.

## Claims

1. A pipelined analogue to digital converter (100), ADC, comprising stages (120, 140) operable during a first (202) and second (206) clock phases; a stage (120) respectively comprising means for performing:

   - during the first clock phase (202),
   ∘ receiving (211, 124) an analogue output signal (111, 311, 511) from a preceding stage (110); and
   - during the second clock phase (206),

      ∘ receiving (231, 127) a digital output signal (112, 312, 512) of the preceding stage (110) and converting (231, 127, 327, 527) it to a quantized analogue signal (128, 328, 548);
      ∘ amplifying (125, 325, 525, 241) a difference (123, 323, 523) between the analogue output signal and the quantized analogue signal thereby obtaining a next analogue output signal (121, 321, 521) for a next stage (140); and
      ∘ quantizing (126, 326, 526, 221) the difference thereby obtaining a next digital output signal (122, 322, 522) for the next stage (140).

2. The ADC (100) according to claim 1 wherein the amplifying (125, 325, 525, 241) and quantizing (126, 326, 526, 221) is performed in parallel during the second clock phase (205).

3. The ADC (100) according to claim 1 wherein subsequent stages (120, 140) are operable according to opposite clock phases (202, 206).

4. The ADC according to any one of claims 1 to 3 wherein the means further comprise an amplifier operable in closed-loop feedback (325) for performing the amplifying (125, 325, 525, 241).

5. The ADC (100) according to any one of claims 1 to 3 wherein the means further comprises a dynamic open-loop amplifier (525, 625) for performing the amplifying (125, 325, 525, 241).

6. The ADC (100) according to claim 5 wherein the dynamic open-loop amplifier (625) further comprises a differential input transistor pair (652a, 652b) configured to convert the difference applied as a differential input voltage to a differential output current according to a transconductance during a configurable time interval, and to charge a capacitive load with the differential current thereby producing the next analogue output signal at the end of the time interval.

7. The ADC (100) according to claim 6 wherein the dynamic open-loop amplifier (625) further comprises a source-degeneration circuitry (653a, 653b) between the source nodes of the differential input transistor pair (652a, 652b).

8. The ADC (100) according to claim 6 or 7 wherein the dynamic open-loop amplifier (625) further comprises linearization circuitries (670a, 670b) configured to draw a linearization current (673a, 673b) from the source of a respective transistor (652a, 652b) of the differential input transistor pair; and wherein the linearization current (673a, 673b) is proportional to the input applied to the respective transistor (652a, 652b) of the differential input transistor pair.

9. The ADC (100) according to claim 8 wherein linearization circuitries (670a, 670b) comprise a respective transistor (671a, 671b) configured to draw the linearization current (673a, 673b).

10. The ADC (100) according to any one of the preceding claims wherein the means further comprise at least one comparator (126, 326, 526) for performing the quantizing.

11. The ADC (100) according to any one of the preceding claims wherein the means further comprise a digital to analogue converter (127, 327, 527), DAC, for performing the converting.

12. The ADC (100) according to any one of the preceding claims wherein the means further comprise at least one switch (341, 342, 541, 542) and at least one capacitor (350, 351, 551) for performing the receiving (211, 124) the analogue output signal (111) by sampling the analogue output signal onto the capacitor.

13. An integrated circuit comprising the ADC according to any of the preceding claims.

14. A method for performing analogue to digital conversion by a synchronous pipeline (100) of subsequent stages (120, 140) comprising, by a respective stage (120):

- during a first clock phase (202),
  ◦ receiving (211, 124) an analogue output signal (111, 311, 511) from a preceding stage (110); and
- during the second clock phase (206),

    ◦ receiving (231, 127) a digital output signal (112, 312, 512) of the preceding stage (110) and converting (231, 127, 327, 527) it to a quantized analogue signal (128, 328, 548);
    ◦ amplifying (125, 325, 525, 241) a difference (123, 323, 523) between the analogue output signal and the quantized analogue signal thereby obtaining a next analogue output signal (121, 321, 521) for a next stage (140); and
    ◦ quantizing (126, 326, 526, 221) the difference thereby obtaining a next digital output signal (122, 322, 522) for the next stage (140).

Fig. 1

Fig. 2

EP 3 866 344 A1

Fig. 3

Fig. 4

EP 3 866 344 A1

Fig. 5

EP 3 866 344 A1

Fig. 6

Europäisches
Patentamt

European
Patent Office

Office européen
des brevets

# EUROPEAN SEARCH REPORT

Application Number

EP 20 15 7326

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BOB VERBRUGGEN ET AL: "A 2.6 mW 6 bit 2.2 GS/s Fully Dynamic Pipeline ADC in 40 nm Digital CMOS", IEEE JOURNAL OF SOLID-STATE CIRCUITS, IEEE, USA, vol. 43, no. 10, October 2010 (2010-10), pages 2080-2090, XP011318982, ISSN: 0018-9200 | 1-3,5-14 | INV. H03M1/06 ADD. H03M1/16 |
| Y | * Title * * abstract * * page 2080, right-hand column, last paragraph - page 2081, left-hand column, paragraph 2 * * page 2083, left-hand column, last paragraph - right-hand column, paragraph 1 * * page 2084, left-hand column, paragraph 1 * * figures 4,5,6,13 * | 4 | |
| X | NAZEMI A ET AL: "A 10.3GS/s 6bit (5.1 ENOB at Nyquist) time-interleaved/pipelined ADC using open-loop amplifiers and digital calibration in 90nm CMOS", VLSI CIRCUITS, 2008 IEEE SYMPOSIUM ON, IEEE, PISCATAWAY, NJ, USA, 18 June 2008 (2008-06-18), pages 18-19, XP031295785, ISBN: 978-1-4244-1804-6 | 1-3, 10-14 | TECHNICAL FIELDS SEARCHED (IPC) H03M |
| Y | * Title * * Sections Architecture and Circuit Implementation; page 18, left-hand column * * figures 1,2,3,6 * | 4 | |

-----

-----

-/--

The present search report has been drawn up for all claims

| Place of search | Date of completion of the search | Examiner |
|---|---|---|
| The Hague | 21 July 2020 | Rocha, Daniel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

**EUROPEAN SEARCH REPORT**

Application Number

EP 20 15 7326

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2019/296756 A1 (ALI AHMED MOHAMED ABDELATTY [US]) 26 September 2019 (2019-09-26) * paragraphs [0050] - [0051]; figures 2,3 * | 4 | |

-----

TECHNICAL FIELDS
SEARCHED      (IPC)

The present search report has been drawn up for all claims

| Place of search | Date of completion of the search | Examiner |
|---|---|---|
| The Hague | 21 July 2020 | Rocha, Daniel |

EPO FORM 1503 03.82 (P04C01)

## ANNEX TO THE EUROPEAN SEARCH REPORT
## ON EUROPEAN PATENT APPLICATION NO.

EP 20 15 7326

This annex lists the patent family members relating to the patent documents cited in the above-mentioned European search report.
The members are as contained in the European Patent Office EDP file on
The European Patent Office is in no way liable for these particulars which are merely given for the purpose of information.

21-07-2020

| Patent document cited in search report | | Publication date | Patent family member(s) | | Publication date |
|---|---|---|---|---|---|
| US 2019296756 | A1 | 26-09-2019 | CN | 110299916 A | 01-10-2019 |
| | | | US | 2019296756 A1 | 26-09-2019 |

EPO FORM P0459

For more details about this annex : see Official Journal of the European Patent Office, No. 12/82